**Europäisches Patentamt**

**European Patent Office**

**Office européen des brevets**

(19)

(11) Numéro de publication : **0 130 128 B1**

(12) **FASCICULE DE BREVET EUROPÉEN**

(45) Date de publication du fascicule du brevet :
07.09.88

(51) Int. Cl.⁴ : **G 11 C 19/08**

(21) Numéro de dépôt : **84401315.1**

(22) Date de dépôt : **22.06.84**

(54) **Mémoire à bulles magnétiques.**

(30) Priorité : 28.06.83 FR 8310664

(43) Date de publication de la demande :
02.01.85 Bulletin 85/01

(45) Mention de la délivrance du brevet :
07.09.88 Bulletin 88/36

(84) Etats contractants désignés :
**DE GB NL**

(56) Documents cités :
**EP-A- 0 038 754**
**US-A- 4 152 777**
**US-A- 4 334 291**

(73) Titulaire : **COMMISSARIAT A L'ENERGIE ATOMIQUE**
**31/33, rue de la Fédération**
**F-75015 Paris (FR)**

(72) Inventeur : **Fedeli, Jean-Marc**
**3, rue Bach Le Fontanil Cornillon**
**F-38120 Saint Egreve (FR)**
Inventeur : **Jouve, Hubert**
**8, Domaine des Plantées**
**F-38330 Biviers (FR)**
Inventeur : **Magnin, Joel**
**3. rue Doyen Gosse**
**F-38400 Saint Martin d'Heres (FR)**
Inventeur : **Pisella, Christian**
**"Le Mollard" Beaucroissant**
**F-38140 Rives sur Fure (FR)**

(74) Mandataire : **Mongrédien, André et al**
**c/o BREVATOME 25, rue de Ponthieu**
**F-75008 Paris (FR)**

EP 0 130 128 B1

### Description

La présente invention concerne une mémoire à bulles magnétiques. Elle s'applique à la mémorisation d'informations binaires, matérialisées sous la forme de domaines magnétiques isolés, qualifiés de bulles ; ces domaines présentent une aimantation inverse de celle du reste du matériau magnétique qui constitue la couche dans laquelle ils sont formés.

On sait que chaque bulle peut être déplacée par une force et que ce déplacement peut s'effectuer librement dans n'importe quelle direction, dans le plan de la couche magnétique. Cette couche magnétique est un grenat magnétique et les bulles sont formées dans ce grenat en lui appliquant un champ magnétique continu perpendiculaire au plan de la couche. Ce champ est produit dans la pratique par un aimant permanent qui assure la non volatilité des informations contenues dans la mémoire.

La couche de grenat magnétique dans laquelle sont formées les bulles, est généralement supportée par un grenat monocristallin amagnétique.

Il est aussi connu de réaliser une mémoire à bulles selon une organisation qui comprend une série de registres mineurs à décalage, orientés longitudinalement et au moins un registre majeur d'accès, orienté transversalement ; ces registres mineurs et majeur sont constitués par des motifs dont les frontières sont définies par les contours de zones ioniquement implantées de la couche de grenat magnétique. De manière connue, le registre d'accès présente un ou plusieurs points d'accès à une extrémité d'accès de chaque registre mineur. Il est également connu d'utiliser des moyens pour déplacer les bulles, dans chaque registre mineur, par application d'un champ magnétique tournant, et d'utiliser des moyens pour déplacer les bulles dans le registre majeur, par circulation de courants dans deux feuilles perforées électriquement conductrices, superposées à la couche de grenat magnétique, isolées entre elles et isolées de cette couche et situées en regard des motifs du registre majeur. Cette mémoire de type connu est par exemple celle qui est décrite dans le brevet français n° 2 480 983 dont la demande a été déposée le 18 avril 1980, au nom du même demandeur.

Dans cette mémoire à bulles de type connu, chaque bulle qui doit être transférée d'un registre mineur à un registre majeur doit être décollée de la frontière du dernier motif du registre mineur correspondant, pour être propagée dans le registre majeur, grâce aux courants électriques circulant dans deux feuilles superposées à la couche de grenat magnétique ; ces bulles circulent soit dans une zone implantée, soit dans une zone non implantée et leur guidage dans le registre majeur vers une station d'accès, nécessite la circulation de courants importants dans les feuilles conductrices, du fait que ces bulles, dans le registre majeur, ne sont pas guidées en permanence le long des frontières de motifs juxtaposés.

La propagation des bulles par circulation de courants dans des feuilles électriquement conductrices est également décrite dans le brevet français n° 2 428 890. Comme dans la mémoire décrite plus haut, les bulles ne s'appuyant plus sur la frontière de motifs définis par implantation ionique, il est nécessaire de recourir à un courant important pour assurer le guidage des bulles vers un point déterminé.

L'invention a pour but de remédier à ces inconvénients et notamment de réaliser une mémoire à bulles magnétiques organisée en registres mineurs et majeur, comprenant des motifs définis par implantation ionique dans une couche de grenat magnétique, dans laquelle les bulles sont déplacées dans les registres mineurs par un champ magnétique tournant et, dans les registres majeurs, par des courants circulant dans des feuilles électriquement conductrices, percées de fenêtres, superposées à la couche de grenat magnétique ; la circulation des bulles dans le registre majeur est telle que ces bulles restent au maximum en contact avec les frontières de motifs définissant ce registre. Cette organisation a pour principal avantage, d'assurer un meilleur guidage des bulles vers une station d'accès, sans avoir à utiliser des courants importants dans les feuilles conductrices.

Un autre avantage important est que, la bulle étant toujours située dans un puits de potentiel créé par la bordure de la zone non implantée, le transfert s'effectue simplement en activant la propagation par courant après la propagation par champ tournant, ou vice-versa.

L'invention a pour objet une mémoire à bulles magnétiques, comprenant une série de registres mineurs à décalage, orientés longitudinalement et au moins un registre majeur d'accès orienté transversalement, ces registres mineurs et majeur comportant des motifs dont les frontières sont définies par des zones ioniquement implantées d'une couche d'un grenant magnétique, des moyens de transfert de bulle d'une extrémité de registre mineur vers le registre majeur, des moyens pour déplacer les bulles dans chaque registre mineur par application d'un champ magnétique tournant, des moyens pour déplacer les bulles dans le registre majeur par circulation de courants dans deux feuilles électriquement conductrices, superposées à la couche de grenat magnétique, isolées entre elles et isolées de cette couche et percées de fenêtres en regard des motifs de ce registre, caractérisée en ce que les bulles circulant dans le registre majeur en restant en contact avec les frontières des motifs du registre majeur dans les zones implantées du grenat, les moyens de transfert comprenant pour chaque registre mineur, à son extrémité, au moins un motif de transfert vers le registre majeur, le motif de transfert empiètant en partie le registre majeur dans la direction transversale, de sorte qu'il recouvre partiellement des fenêtres du registre majeur pour que des bulles dupliquées dans le registre mineur soient reçues en regard de deux fenêtres distinctes du registre majeur.

Selon un mode de réalisation particulier, le registre majeur comprend des successions de motifs correspondant respectivement à chaque registre mineur, séparées par des zones implantées et disposées latéralement par rapport aux registres mineurs, les fenêtres dans chacune des deux feuilles conductrices présentant des portions de surface communes avec les motifs du registre majeur pour chaque succession de motifs, au moins l'une des deux feuilles présentant une fenêtre entre chaque succession de motif du registre majeur ;

Selon un autre mode de réalisation particulier, les moyens de transfert comprennent des registres tampons disposés longitudinalement, respectivement entre les extrémités d'accès des registres mineurs et les successions de motifs du registre majeur, chaque registre tampon étant constitué par des motifs définis par implantation ionique de la couche de grenat magnétique, les motifs d'extrémité de transfert de bulles de chaque registre tampon empiètant partiellement le registre majeur dans la direction transversale, de sorte qu'il recouvre partiellement des fenêtres du registre majeur pour que des bulles dupliquées dans le registre mineur, soient reçues en regard de deux fenêtres distinctes du registre majeur, les moyens de transfert comportent en outre un conducteur électrique superposé à la couche de grenat magnétique et isolé de celle-ci apte à recevoir des impulsions de courant de transfert, ce conducteur étant orienté transversalement et formant des créneaux reliant respectivement les extrémités d'accès des registres mineurs et les registres tampons correspondants, les impulsions commandant le transfert des bulles dupliquées présentes aux extrémités des registres mineurs, vers les extrémités des registres tampons correspondants.

Enfin, selon encore un autre mode de réalisation, le registre majeur comprend des motifs adjacents d'accès au registre mineur, disposés latéralement, les moyens d'accès étant constitués respectivement par des motifs d'extrémité des registres mineurs alignés avec les motifs adjacents d'accès, séparés entre eux par des zones implantées, les fenêtres dans chacune des deux feuilles conductrices présentant des portions de surface communes avec les motifs du registre majeur, au moins l'une des deux feuilles présentant une fenêtre entre les motifs d'extrémité.

Les caractéristiques et avantages de l'invention ressortiront mieux de la description qui va suivre, donnée en référence aux dessins annexés dans lesquels :

— la figure 1 représente schématiquement en vue de dessus un premier mode de réalisation d'une mémoire à bulles, conforme à l'invention,

— la figure 2 représente schématiquement et en vue de dessus un second mode de réalisation d'une mémoire à bulles conforme à l'invention.

— La figure 3 est une coupe schématique transversale partielle de la mémoire de la figure 1, en regard du registre d'accès.

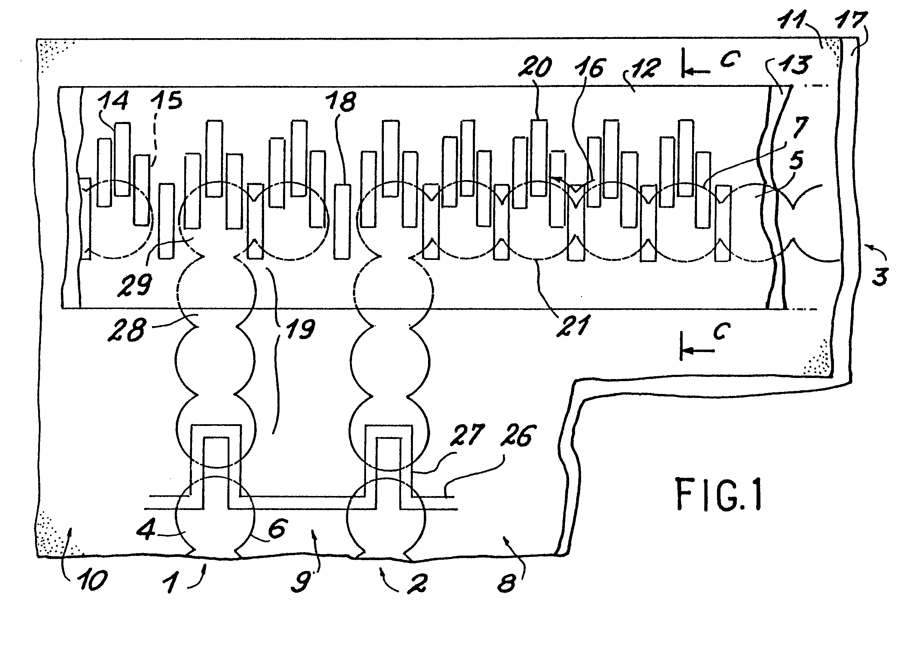

— La figure 1 représente schématiquement, en vue de dessus un premier mode de réalisation d'une mémoire à bulles conforme à l'invention. Cette mémoire comprend une série de registres à décalage 1,2,... dont le nombre a été limité à deux sur la figure pour en faciliter la représentation. Ces registres mineurs sont orientés longitudinalement. La mémoire comprend aussi au moins un registre majeur 3, orienté transversalement par rapport aux registres mineurs. Les registres mineurs et majeur sont constitués par des motifs tels que 4, 5, dont les frontières 6, 7 sont définies par des zones 8, 9, 10,... d'implantation ionique dans une couche 11 d'un grenat magnétique supporté par un substrat amagnétique 17. Dans l'exemple de réalisation représenté sur cette figure, les motifs ont une forme circulaire, mais il est évident que toute autre forme pourrait convenir et en particulier une forme en losange par exemple. Les frontières de ces motifs, dans ce mode de réalisation, sont des cercles ; ces cercles sont tangents entre eux pour les registres mineurs 1, 2. Le registre majeur 3 présente des successions de motifs circulaires séparées par des zones implantées de la couche de grenat magnétique 11. Dans chaque succession, les frontières des motifs sont des cercles tangents entre eux. L'intérieur des motifs pour les registres mineurs et les registres majeurs sont des zones non implantées de la couche 11 de grenat magnétique. La mémoire à bulles représentée sur cette figure comprend aussi, des moyens pour déplacer les bulles dans chaque registre mineur, par application d'un champ magnétique tournant. Ces moyens connus ne sont pas représentés sur la figure. Les bulles sont déplacées dans le registre majeur 3, par circulation de courants dans deux feuilles électriquement conductrices 12, 13 superposées à la couche de grenat magnétique 11, isolées entre elles, isolées de la couche de grenat et percées de fenêtres 14, 15, 20, en regard des motifs du registre majeur 3. Selon l'invention, ces fenêtres sont disposées de manière que les bulles soient déplacées, tel que représenté par la flèche 16, en restant en contact avec les frontières des motifs 5 du registre majeur, dans les zones implantées du grenat 11. La circulation d'une bulle entre deux motifs appartenant respectivement à deux successions adjacentes de motifs du registre majeur, est assurée grâce au courant circulant dans la feuille conductrice 12 et grâce à des fenêtres intermédiaires 18. Cette structure de mémoire permet d'assurer un bon guidage des bulles dans le registre majeur, sans avoir à utiliser des courants intenses dans les feuilles conductrices 12, 13.

En arrêtant le champ tournant, les bulles sont propagées dans le registre majeur, dans le sens de la flèche 16 par exemple, au moyen de courants circulant dans les feuilles conductrices 12, 13. Chaque bulle peut être dirigée vers une station de réception non représentée sur la figure, ou peut être transférée d'un registre mineur à un autre registre mineur.

La mémoire comporte aussi des moyens de transfert des bulles des extrémités des registres mineurs vers le registre majeur 3 ; dans ce premier mode de réalisation, les moyens de transfert comprennent des registres tampons 19 disposés longitudinalement, respectivement entre les extrémités d'accès (motifs 4) des registres mineurs 1 et les successions de motifs du registre majeur 3. Ces registres tampons sont constitués par des motifs définis par implantation ionique de la couche de grenat magnétique 11. Ils sont orientés longitudinalement comme les registres mineurs correspondants. Les moyens de transfert comprennent aussi un conducteur électrique 26, apte à recevoir des impulsions de courant de transfert ; ce conducteur est orienté transversalement, comme le registre majeur 3, et il forme des créneaux 27 qui relient respectivement les extrémités d'accès des registres mineurs 1 avec les registres tampons correspondants. Chaque registre tampon 19 comprend au moins un motif d'extrémité 28 qui est adjacent à un motif 29 de la succession correspondante de motifs du registre majeur 3. Dans ce premier mode de réalisation, la structure de la mémoire à bulles permet, de façon connue, de dupliquer les bulles présentes aux extrémités des registres mineurs des registres tampons, avant d'assurer leur transfert. Cette duplication s'effectue de façon connue et elle n'est pas décrite ici en détail. Le conducteur 26 associé aux registres tampons joue le rôle de porte de transfert.

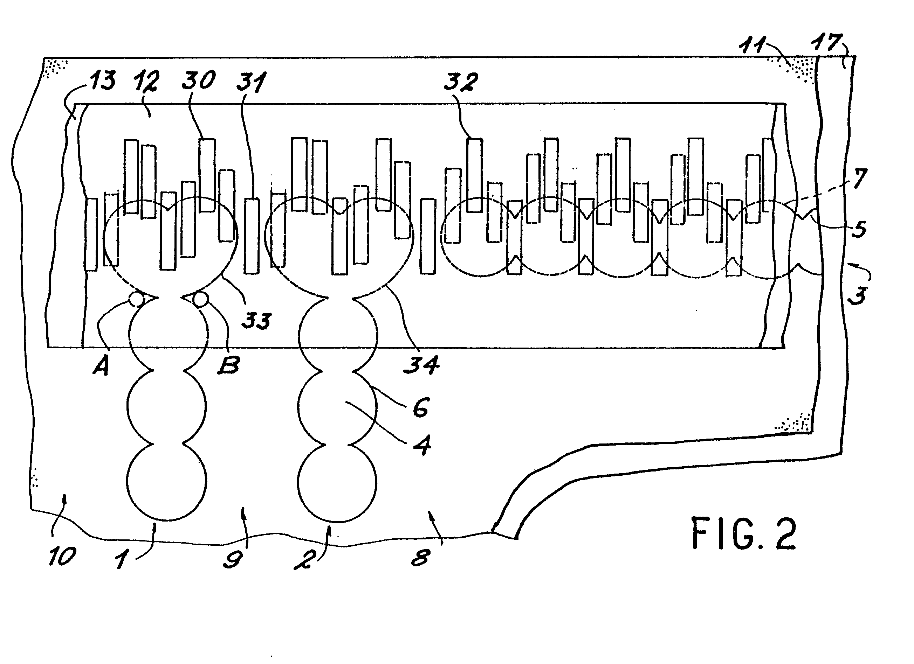

La figure 2 représente un deuxième mode de réalisation de la mémoire de l'invention. Les mêmes éléments portent les mêmes références sur cette figure et sur la figure 1. On distingue sur cette figure, les registres mineurs 1, 2 et le registre majeur 3, constitués par des motifs tels que 4, 5, dont les frontières 6, 7, sont définies par des zones 8, 9, 10 d'implantation ionique dans la couche 11 de grenat magnétique supportée par le substrat amagnétique 17. On distingue aussi les deux feuilles conductrices 12, 13 superposées à la couche de grenat magnétique 11, isolées entre elles, isolées de la couche de grenat et percées de fenêtres 30, 31, 32,.... Dans ce mode de réalisation, le registre majeur 3 comprend des motifs 5 adjacents, d'accès aux registres mineurs. Ces motifs d'accès sont disposés latéralement. Les moyens d'accès sont ici constitués respectivement par des motifs 33, 34, situés aux extrémités des registres mineurs 1, 2 et alignés avec les motifs d'accès du registre majeur 3. Ces motifs d'extrémité 33, 34 sont séparés entre eux par des zones non implantées du substrat 11. Les fenêtres 32 dans chacune des feuilles conductrices 12, 13 présentent des portions de surface communes avec les motifs 5 du registre majeur 3. L'une des feuilles conductrices telle que la feuille 12 par exemple, présente des fenêtres 31 entre les motifs d'extrémité 33, 34 des registres mineurs. La forme de chaque motif d'extrémité est telle que ce motif rend possible le transfert séparé de deux bulles A, B, présentes dans un registre mineur, vers les motifs d'accès 5 du registre majeur 3. Dans ce mode de réalisation, les bulles A, B peuvent être déplacées en même temps en direction du registre majeur ou d'un autre registre mineur, ce qui permet de doubler le débit d'informations dans la mémoire. Les motifs d'extrémité 33, 34 ont la forme de coeurs, mais il est bien évident que toute autre forme permettant d'accéder simultanément à deux bulles contenues dans un registre mineur, peut convenir.

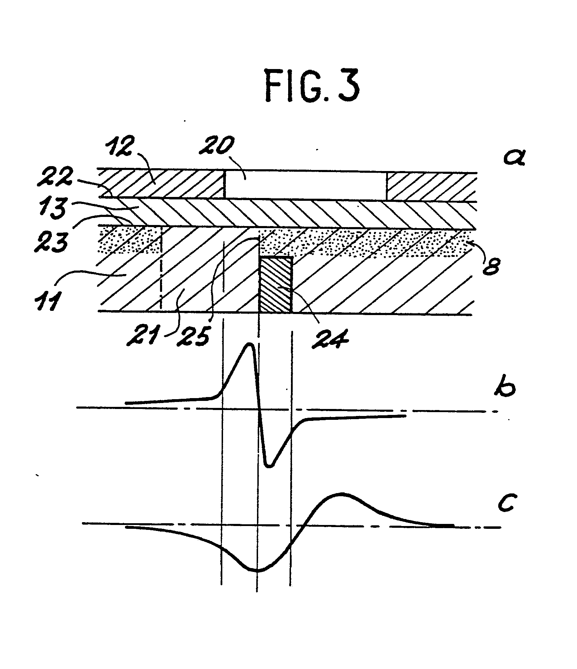

La figure 3 représente schématiquement en (a) une coupe latérale partielle C de la mémoire de la figure 1. Cette figure permet de mieux comprendre le cheminement des bulles dans le registre majeur 3. On distingue sur cette figure les couches conductrices 12, 13 électriquement isolées entre elles par la couche isolante 22 et isolées de la couche de grenat magnétique 11 par une couche isolante 23. Sur cette figure, la zone d'implantation ionique dans le grenat magnétique 11 est représentée en 8, tandis que le motif non implanté sur la frontière duquel s'appuie une bulle 24, est représenté schématiquement en 21. La frontière 25 entre la zone implantée 8 du grenat magnétique 11 et la zone non implantée 21 de cette couche (représentée par des hachures sur cette figure) est une limite importante : sur cette limite existe un puits de champ magnétique tel que représenté sur le diagramme (3b) ; le champ magnétique créé par la circulation du courant dans les feuilles conductrices est représenté sur le diagramme (3c). Ce puits de champ s'ajoute à celui existant sur les frontières des zones non implantées (diagramme (3b)) et permet de propager les bulles. Le puits de champ magnétique représenté sur le diagramme (3b) permet de maintenir la bulle 24 en contact avec la frontière 25. La bulle se déplace en restant en contact avec cette frontière, lorsque le courant circule dans les feuilles conductrices. Lorsque les bulles circulent dans les registres mineurs, grâce à l'application d'un champ tournant elles restent aussi en contact avec les frontières des motifs correspondants. Le puits de potentiel créé sur les frontières des motifs non implantés dans le registre majeur 3 évite le décollage des bulles par rapport à ces frontières. Les puits de champ magnétique sur les frontières des motifs du registre majeur servent à guider les bulles tandis que les fenêtres dans les feuilles conductrices servent à propager les bulles grâce aux courants dans ces feuilles. Les mêmes applications sont bien entendu applicables au mode de réalisation de la figure 2.

L'invention permet bien d'atteindre les buts mentionnés plus haut : les bulles circulent dans le registre majeur sans qu'il soit nécessaire d'utiliser des courants importants dans les feuilles électriquement conductrices ; les bulles restent en contact avec les motifs non implantés de ce registre ; elles circulent également dans les registres mineurs grâce à l'application d'un champ tournant, tout en restant en contact avec les frontières des motifs non implantés de ces registres. Le guidage des bulles est donc assuré parfaitement.

Un autre avantage important est que, la bulle étant toujours située dans un puits de potentiel créé par la bordure de la zone non implantée, le transfert s'effectue simplement en activant la propagation par courant après la propagation par champ tournant, ou vice-versa.

**Revendications**

1. Mémoire à bulles magnétiques comprenant une série de registres mineurs (1, 2,...) à décalage, orientés longitudinalement et au moins un registre majeur d'accès (3) orienté transversalement, ces registres mineurs (1, 2,...) et majeur (3) comportant des motifs (4, 5) dont les frontières (6, 7) sont définies par des zones (8, 9, 10) ioniquement implantées d'une couche (11) d'un grenat magnétique, des moyens (26) de transfert de bulle d'une extrémité de registre mineur vers le registre majeur (3), des moyens pour déplacer les bulles dans chaque registre mineur (1, 2) par application d'un champ magnétique tournant, des moyens (12, 13) pour déplacer les bulles dans le registre majeur (3) par circulation de courants dans deux feuilles (12, 13) électroniquement conductrices, superposées à la couche de grenat magnétique (11), isolées entre elles et isolées de cette couche et percées de fenêtres (14, 15, 20, 18) en regard des motifs de ce registre, caractérisée en ce que les bulles circulant dans le registre majeur en restant en contact avec les frontières (7) des motifs (5) du registre majeur dans les zones implantées du grenat (11), les moyens de transfert comprenant pour chaque registre mineur, à son extrémité, au moins un motif (28 ou 33) de transfert vers le registre majeur, le motif de transfert empiètant en partie le registre majeur dans la direction transversale, de sorte qu'il recouvre partiellement des fenêtres du registre majeur pour que des bulles dupliquées dans le registre mineur soient reçues en regard de deux fenêtres distinctes du registre majeur.

2. Mémoire à bulles selon la revendication 1, caractérisée en ce que le registre majeur (3) comprend des successions de motifs (5) correspondant respectivement à chaque registre mineur (1, 2), séparées par des zones implantées et disposées latéralement par rapport aux registres mineurs (1, 2), les fenêtres (14, 15) dans chacune des deux feuilles conductrices (12, 13) présentant des portions de surface communes avec les motifs (5) du registre majeur (3) pour chaque succession de motifs, au moins l'une des deux feuilles présentant une fenêtre (18) entre chaque succession de motifs du registre majeur ;

3. Mémoire à bulles selon la revendication 2, caractérisée en ce que les moyens de transfert comprennent des registres tampons (19) disposés longitudinalement, respectivement entre les extrémités d'accès des registres mineurs (1) et les successions de motifs du registre majeur (3), chaque registre tampon étant constitué par des motifs définis par implantation ionique de la couche de grenat magnétique (10), les motifs d'extrémité de transfert de bulles de chaque registre tampon empiètant partiellement le registre majeur dans la direction transversale, de sorte qu'il recouvre partiellement des fenêtres du registre majeur pour que des bulles dupliquées dans le registre mineur soient reçues en regard de deux fenêtre distinctes du registre majeur ; les moyens de transfert comportent en outre un conducteur électrique (26) superposé à la couche de grenat magnétique et isolé de celle-ci apte à recevoir des impulsions de courant de transfert, ce conducteur étant orienté transversalement et formant des créneaux reliant respectivement les extrémités d'accès des registres mineurs et les registres tampon correspondants, les impulsions commandant le transfert des bulles dupliquées présentes aux extrémités des registres mineurs, vers les extrémités des registres tampon correspondants.

4. Mémoire à bulles selon la revendication 1, caractérisée en ce que le registre majeur (3) comprend des motifs adjacents d'accès aux registres mineurs, disposés latéralement, les moyens d'accès étant constitués respectivement par des motifs d'extrémité des registres mineurs alignés avec les motifs adjacents d'accès, séparés entre eux par des zones implantées, les fenêtres (32) dans chacune des deux feuilles conductrices (12, 13) présentant des portions de surface communes avec les motifs (5) du registre majeur (3), au moins l'une des deux feuilles présentant une fenêtre (31) entre les motifs d'extrémité (33, 34).

**Claims**

1. Magnetic bubble memory having a series of longitudinally oriented minor shift registers (1,2, etc) and at least one transversely oriented major access register (3), said minor (1,2, etc) and major (3) registers having patterns (4, 5), whereof the boundaries (6, 7) are defined by ionically implanted zones (8,9,10) of a magnetic garnet layer (11), means (26) for transferring the bubble from one end of the minor register to the major register (3), means for displacing the bubbles in each minor register (1, 2) by applying a rotating magnetic field, means (12, 13) for displacing the bubbles in the major register (3) by the circulation of currents in two electrically conductive sheets (12, 13) superimposed on the magnetic garnet layer (11), which are isolated from one another and from said layer and which are provided with windows (14, 15, 20, 18) facing the patterns of said register, characterized in that the bubbles circulate in the major register whilst remaining in contact with the boundaries (7) of the patterns (5) of the major register in the implanted areas of garnet (11), the transfer means having for each minor register, at the end thereof, at least one pattern (28 or 33) for transfer to the major register, the transfer pattern encroaching in part on the major register in the transverse direction, so that it partly covers the windows of the major register and as a result bubbles duplicated in the minor register are received facing two separate windows of the major register.

2. Bubble memory according to claim 1, characterized in that the major register (3) comprises successions of patterns (5) respectively corresponding to each minor register (1, 2), separated by implanted zones and positioned laterally with respect to the minor registers (1, 2), the windows (14, 15) in each of the two conductive sheets (12, 13) having common surface portions with the patterns (5) of the major register (3) for each succession of patterns, at least one of the two sheets having a window (18) between each succession of patterns of the major register.

3. Bubble memory according to claim 2, characterized in that the transfer means comprise longitudinally positioned buffer registers (19) respectively between the access ends of the minor registers (1) and the successions of patterns of the major register (3), each buffer register being constituted by patterns defined by the ionic implantation of the magnetic garnet layer (10), the end patterns for the transfer of bubbles of each buffer register partly encroaching on the major register in the transverse direction, so that it partly covers the windows of the major register and as a result duplicated bubbles in the minor register are received facing two separate windows of the major register, the transfer means also having an electrical conductor (26) superimposed on the magnetic garnet layer and isolated therefrom so as to be able to receive transfer current pulses, said conductor being transversely oriented and forming indentations respectively connecting the access ends of the minor registers and the corresponding buffer registers, the pulses controlling the transfer of duplicated bubbles present at the ends of the minor registers to the ends of the corresponding buffer registers.

4. Bubble memory according to claim 1, characterized in that the major register (3) comprises access means adjacent to the laterally positioned minor registers, the access means being constituted respectively by the end patterns of the minor registers aligned with the adjacent access patterns, separated from one another by implanted zones, the windows (32) in each of the two conductive sheets (12, 13) having common surface portions with the patterns (5) of the major register (3), at least one of the two sheets having a window (31) between the end patterns (33, 34).

**Patentansprüche**

1. Magnetischer Blasenspeicher mit einer Reihe von längsausgerichteten Unterschieberegistern (1, 2,...) und wenigstens einem quer ausgerichteten Hauptzugriffsregister (3), wobei die Unterregister (1, 2,...) und das Hauptregister (3) umfassen Muster (4, 5), deren Grenzen (6, 7) von ionenimplantierten Bereichen (8, 9, 10) einer magnetischen Granatschicht (11) begrenzt sind, Mittel (26) zum Überführen von Blasen von einem Ende des Unterregisters zu dem Hauptregister (3), Mittel zum Verschieben der Blasen in jedem Unterregister (1, 2) durch Anwenden eines magnetischen Drehfelds, Mittel (12, 13) zum Verschieben der Blasen in dem Hauptregister (3) durch strömfluß in zwei elektrisch leitenden Schichten, die der magnetischen Granatschicht (11) überlagert, voneinander und von dieser Schicht isoliert und mit den Mustern dieses Registers gegenüberliegenden Fenstern (14, 15, 20, 18) durchbrochen sind, dadurch gekennzeichnet, daß die in dem Hauptregister wandernden Blasen mit den Grenzen (7) der Muster (5) des Hauptregisters in den implantierten Bereichen des Granats (11) in Berührung bleiben, die Mittel zum überführen für jedes Unterregister an dessen Ende wenigstens ein Muster (28 oder 33) zur Überführung zu dem Hauptregister aufweisen, wobei das Überführungsmuster teilweise das Hauptregister in der Querrichtung übergreift derart, daß es teilweise Fenster des Hauptregisters überdeckt, damit in dem Unterregister verdoppelte Blasen von dem Hauptregister zwei bestimmten Fenstern gegenüberliegend empfangen werden.

2. Blasenspeicher nach Anspruch 1, dadurch gekennzeichnet, daß das Hauptregister (3) dem jeweiligen Unterregister (1, 2) entsprechende Folgen von Mustern (5) aufweist, die von den implantierten Bereichen getrennt und in bezug auf die Unterregister (1, 2) seitlich angeordnet sind, die Fenster (14, 15) in jeder der zwei leitenden Schichten (12, 13) für jede Folge von Mustern mit den Mustern (5) des Hauptregisters (3) gemeinsame Flächenbereiche aufweisen, wobei wenigstens eine der zwei Schichten ein Fenster (18) zwischen jeder Folge von Mustern des Hauptregisters besitzt.

3. Blasenspeicher nach Anspruch 2, dadurch gekennzeichnet, daß die Überführungsmittel Pufferregister (19) umfassen, die in Längsrichtung jeweils zwischen den Zugriffsenden der Unterregister (1) und der Folge von Mustern des Hauptregisters (3) angeordnet sind, jedes Pufferregister von durch Ionenimplantation der magnetischen Granatschicht (10) festgelegte Muster gebildet ist, die Endmuster zur Überführung von Blasen eines jeden Pufferregisters teilweise das Hauptregister in der Querrichtung übergreifen derart, daß sie teilweise Fenster des Hauptregisters überdecken, damit in dem Unterregister verdoppelte Blasen zwei bestimmten Fenstern des Hauptregisters gegenüberliegend empfangen werden, die Überführungsmittel ferner einen elektrischen Leiter (26) aufweisen, der der magnetischen Granatschicht überlagert und von dieser isoliert ist und Überführungsstromimpulse empfangen kann, wobei dieser Leiter quer ausgerichtet ist und Zacken bildet, die die jeweiligen Zugriffsenden der Unterregister und die entsprechenden Pufferregister verbinden und wobei die Impulse die Überführung der an den Enden der Unterregister vorliegenden, verdoppelten Blasen zu den Enden der entsprechenden Pufferregister steuern.

4. Blasenspeicher nach Anspruch 1, dadurch gekennzeichnet, daß das Hauptregister (3) dem Zugriff der Unterregister benachbarte Muster aufweist, die seitlich angeordnet sind, die Zugriffsmittel jeweils von Endmustern der Unterregister gebildet sind, die mit den den Zugriffen benachbarten Mustern ausgerichtet und voneinander durch implantierte Bereiche getrennt sind, die Fenster (32) in jeder der zwei leitenden schichten (12, 13) mit den Mustern (5) des Hauptregisters (3) gemeinsame Flächenbereiche aufweisen, wobei wenigstens eine der zwei Schichten ein Fenster (31) zwischen den Endmustern (33, 34) besitzt.

FIG.1

0 130 128

FIG. 2

# FIG.3